# EUROPEAN PATENT APPLICATION

(11) **EP 2 065 921 A1**
(43) Date of publication of application: **03.06.2009**
(21) Application number: 07291420.3
(22) Date of filing: 29.11.2007
(51) Int. Cl.: H01L 21/18, H01L 21/20, H01L 21/762

(54) **Method for fabricating a semiconductor substrate with areas with different crystal orienation**

(71) Applicant: S.O.I. TEC Silicon on Insulator Technologies, 38190 Bernin (FR)
(72) Inventor: Bourdelle, Konstantin, 38920 Crolles (FR)
(74) Representative: Grünecker, Kinkeldey, Stockmair & Schwanhäusser Anwaltssozietät

(57) **Abstract**

The present invention is related to a method for fabricating a semiconductor substrate having on its surface areas with different crystal orientation. It is the object of the present invention to provide the method of the above-mentioned type, wherein the resulting substrates are nearly defect free and wherein the method is relatively quick, easy to apply and not limited to a certain top layer thickness of the semiconductor substrate. The object is solved by a method of the above-mentioned type comprising the steps of bonding of a first semiconductor substrate with a second semiconductor substrate, said semiconductor substrates having bulk regions with different crystal orientation; forming a mask on the surface of the first semiconductor substrate, said mask being reflective for laser light; forming openings in said mask to expose unmasked bulk regions of the first semiconductor substrate; exposing at least said openings to laser light and melting locally the unmasked bulk regions of said first semiconductor substrate and at least a part of the bulk region of the second semiconductor substrate with said laser light.

## Description

The present invention relates to a method for fabricating a semiconductor substrate having on its surface areas with different crystal orientation.

Substrates of the above-mentioned type are known as so-called hybrid orientation substrates, comprising different semiconductor regions with a first crystalline orientation and other regions with a second crystalline orientation. Such substrates are of interest for the fabrication of CMOS semiconductor devices comprising n- and p-FET's (Field Effect Transistors). Favourably, n-FET's are built on (100) oriented silicon while p-FET's are prepared on (110) oriented silicon, because it is known that hole mobility is more than doubled on (110) silicon substrates compared with conventional (100) substrates, wherein electron mobility is the highest on (100) substrates.

The document US 5,384,473 contains different semiconductor substrates having element formation surfaces with different orientations. According to one example, a silicon wafer with (100) orientation is bonded with a silicon support substrate of (110) orientation. Thereafter, the upper (100) silicon wafer is masked and etched to make an opening that allows the main surface of the support Si (110) substrate to appear at the bottom. Then, sidewalls of silicon nitride are formed on the sides of the openings. Next, an epitaxial silicon layer is grown on the exposed support substrate using the support substrate as seed crystal. Accordingly, the grown material has the same (110) orientation as that of the surface of the support substrate. In this way, a silicon substrate can be produced having portions of different surface orientations: a portion with the (100) plane of the upper Si wafer and a portion with the (110) plane.

The paper of Yang et al.: "High Performance CMOS Fabricated on Hybrid Substrate with Different Crystal Orientations", IEDM 2003, pp 453 - 456, describes another method to form a hybrid substrate with different crystal orientations at its surface. In the proposed technology, the hybrid substrate is formed by a layer transfer technique through wafer bonding. First, hydrogen is implanted into an oxidized silicon substrate with (110) orientation or (100) orientation. Then, the wafer is bonded with a handle wafer with different surface orientation. Thereafter follows a heat treatment to split the hydrogen-implanted wafer and strengthen the bonding. Afterwards, the top SOI (Sillicon On Insulator) layer is polished and thinned down to a desired thickness. Then, the upper transferred layer is masked and the transferred layer as well as the buried oxide layer is etched. Thereafter, silicon nitride spacers are formed on the sidewalls of the etched region. Finally, a silicon epitaxy and CMP (Chemical Mechanical Polishing) is applied to grow in the formed opening epitaxial silicon with the same crystal orientation as the handle wafer.

Although the above-described technologies are, in general, suited to form hybrid orientation substrates, they have the problem that they are rather time-consuming due to the time necessary to grow epitaxially the material of the underlying substrate up to the top of the upper substrate or layer. Moreover, the final structures can contain some defects after epitaxy. The epitaxy defects may appear due to incomplete removal of the residual oxygen between the different substrates or particles on the surface before epitaxy.

The CMOS process sequence for HOT (Hybrid Orientation Technology) SOI incorporates a trench etch and epitaxy steps, i.e. regions of top Si having one orientation are etched away and are then replaced by epitaxial Si having another crystal orientation. As a result, the final device has a mixture of bulk and SOI transistors with more complex process integration and circuit design.

Another approach to produce hybrid orientation substrates without a buried oxide between layers of different crystal orientations is disclosed in the paper of Saenger et al.: "Amorphization/templated recrystallization method for changing the orientation of single crystal silicon: An alternative approach to hybrid orientation substrates", published in Applied Physics Letters 87, 221911 (2005). The authors of this paper suggest a method to change the orientation of selected silicon regions with amorphization/templated recrystallization (ATR). The ATR technique uses a starting substrate comprising a thin overlayer of (100) or (110) Si on a (110) or (100) Si handle wafer. Then follows a Si+ or Ge+ ion implantation at selected areas of the surface of the starting substrate to create an amorphous silicon layer extending from the top of the overlayer to a depth below the overlayer/handle wafer interface. Thereafter, a thermal anneal is applied to produce the handle wafer templated epitaxial recrystallization of the amorphous Si layer. During recrystallization, the support substrate is used as seed, resulting in a zone at the surface of the substrate having the same orientation as the support substrate.

The technique of amorphization and recrystallization has the disadvantage that the final structures can have implant-induced defects after the recrystallization phase. Furthermore, the ATR method is a multiple step process, using high temperature annealing and is limited to a specific thickness of top layers because of the limitation of the implantation energy.

It is therefore the object of the present invention to provide a method for fabricating a semiconductor substrate having on its surface areas with different crystal orientation, wherein the resulting substrates are nearly defect free and wherein the method is relatively quick, easy to apply and not limited to a certain top layer thickness.

The problem is solved by a method for fabricating a semiconductor substrate having on its surface areas with different crystal orientation, wherein the method comprises the steps of bonding of a first semiconductor substrate with a second semiconductor substrate, said semiconductor substrates having bulk regions with different crystal orientation; forming a mask on the surface of a first one of said bonded semiconductor substrates, said mask being reflective for laser light; forming openings in said mask to expose unmasked bulk regions of the first semiconductor substrate; exposing at least said openings to laser light and melting locally the unmasked bulk regions of said first semiconductor substrate and at least a part of the bulk region of the second semiconductor substrate with said laser light.

The invention has the advantage that it provides a method for fabricating hybrid orientation semiconductor substrates with high crystal quality. The laser annealing can be directly applied on the opened areas of the upper bonded semiconductor substrate and leads to a very fast melting of the semiconductor regions exposed to the laser light. This results, temporarily, in the formation of a liquid phase of the said semiconductor regions. The solid material of the support semiconductor substrate underlying this liquid phase serves as a seed for the recrystallization of the overlying liquid material wherein the recrystallization process is comparable with a liquid phase epitaxy. In this way, the recrystallized material can be grown with the crystal orientation of the support semiconductor substrate. Moreover, the regrown material in the openings has the advantage that it has nearly no defects since during melting the former interface between the bonded semiconductor substrates is also melted, resulting in a dissolution of residual oxygen or particles at said interface so that the recrystallization can be performed on the pure semiconductor crystal of the material of the underlying semiconductor substrate.

In a favorable embodiment of the present invention, at least residual oxide and/or oxygen particles at an interface between the first semiconductor substrate and the second semiconductor substrate are dissolved by said melting step.

According to a favourite example of the present invention, said bonding step comprises the bonding of a first silicon wafer with (110) orientation and a second silicon wafer with (100) orientation. By means of this method, a hybrid orientation silicon substrate with (110) oriented surface areas and with (100) oriented surface areas can be produced, wherein both areas have a high quality. Such silicon substrates are especially suited for the fabrication of CMOS semiconductor devices comprising n-FET's and p-FET's.

In a beneficial example of the present invention, the thickness of the first semiconductor substrate is reduced before the melting step to a thickness of about 100 nm to about 200 nm. This thickness is high enough to accommodate in the according region semiconductor devices and permits, moreover, a very fast and complete melting of the opened regions during laser light annealing.

In the case of the BESOI (Bonded and Etched-Back Silicon On Insulator) technology, after a bonding step and a heat treatment up to about 1200 °C to strengthen the bonding interface, a mechanical reduction of the thickness of the first semiconductor substrate is realized leading to a target thickness of the overlying semiconductor material which is submitted to the laser treatment.

It is furthermore advantageous if said bonding step comprises bonding of a first substrate having a bulk region of silicon with a first crystal orientation and having at least an insulator layer on its surface with a second substrate having a bulk region of silicon with a second crystal orientation, resulting in a compound of substrates having said insulator layer at an interface between the regions of silicon, wherein a heat treatment with a temperature between about 1000 °C and about 1300 °C is applied on said compound to dissolve said insulator layer at said interface. This embodiment of the invention is especially suited to form hybrid orientation substrates from semiconductor substrates in which the upper layer was transferred by a Smart Cut^{™} process or BESOI technology. By the suggested heat treatment, the insulator layer between the bonded substrates can be dissolved before the laser treatment. Thereafter, the laser treatment leads, as mentioned above, to a local melting of the unmasked bulk regions of the upper semiconductor substrate and of at least a part of the bulk region of the underlying semiconductor substrate without any disturbance by particles, residues or by an insulator layer between the bonded substrates. In doing so, there exists a nearly perfect space for recrystallization of the melted material in the openings.

According to another advantageous embodiment of the invention, said insulator layer is of silicon dioxide, being a native oxide and/or being formed on the first substrate by thermal oxidization or by chemical wafer deposition. This oxide layer is especially well suited to form a good bonding between the bonded semiconductor substrates, wherein the silicon dioxide layer can be dissolved at the interface between the semiconductor substrates, independently from the way of formation of the silicon dioxide layer, by the above-described heat treatment under inert and/or reductive atmosphere.

Preferably, said insulator layer is being formed on the first substrate with a thickness of less than 200 nm, preferably with a thickness of less than 100 nm, and more particularly with a thickness between about 25 nm and about 50 nm. The lower the thickness of the insulator layer, the easier is its dissolution at the interface between the semiconductor substrates so that the melting step by laser treatment can be performed without disturbing substances at the interface between the semiconductor substrates.

In a further example of the present invention, a heat treatment with a temperature between about 200 °C and 1200 °C is applied on the bonded semiconductor substrates after the bonding step. This heat treatment strengthens the bonding interface between the semiconductor substrates. The temperature range up to 1200 °C includes a transfer of the upper semiconductor layer by a Smart Cut^{™} process as well as the application of the BESOI approach.

In a beneficial variant of the invention, the first substrate is implanted before bonding. This implantation creates a pre-weakened area in the first substrate along which the first substrate can be split during a heat or mechanical treatment performed thereafter. By this step, the thickness of the first substrate lying on top of the bonded substrates can be favourably reduced to get a thickness of the overlying semiconductor material that is low enough to perform an effective melting of certain areas of the substrate by laser treatment.

In a yet further advantageous embodiment of the present invention, a layer from said first substrate is detached after said bonding step by applying a heat treatment with a temperature between about 300 °C and about 500 °C. By the combination of implantation and heat treatment, a layer with a certain thickness can be favorably removed from the first substrate, resulting in a layer thickness of the semiconductor substrate on top of the bonded substrates that is low enough to achieve an effective melting of certain regions of the substrate during laser treatment.

Favourably, the laser light is applied by conventional pulsed laser apparatuses. The interaction of the pulsed laser with Si material leads to very fast heating of the top Si layer, up to the melting temperature of 1687 K or 1414 °C. That laser-silicon interaction results in a very effective and fast melting of the unmasked regions of the semiconductor substrates. If Ge is used as the overlying semiconductor material in the present invention, the necessary melting temperature of 1211 K or 937 °C can also easily be achieved by using a pulsed laser equipment.

More particularly, the laser light is applied with a XeCl excimer laser equipped with a beam homogenizer. This kind of laser can, for instance, be used to melt (110) oriented silicon with a thickness of about 200 nm or a lower thickness. In other examples of the present invention, other suitable lasers can be applied.

Further advantageous features of the present invention will become more apparent with the following detailed description when taken with reference to the accompanying drawings in which:
- Figure 1: schematically shows a compound of bonded semiconductor substrates with different crystal orientation;
- Figure 2: schematically shows a compound of Figure 1 after a reduction of the thickness of the upper semiconductor substrate of the compound;
- Figure 3: schematically shows the compound of Figure 2 wherein a mask is provided on the upper semiconductor substrate;
- Figure 4: schematically shows the compound of Figure 3 during a laser treatment;
- Figure 5: schematically shows the compound of Figure 4 with melted areas;

- Figure 6: schematically shows the compound of Figure 5 after recrystallization of the melted areas;
- Figure 7: schematically shows the compound of Figure 6 after removal of the mask;
- Figure 8: schematically shows a first semiconductor substrate with a first crystal orientation having on top an insulator layer;
- Figure 9: schematically shows the semiconductor substrate of Figure 8 during an implantation step;
- Figure 10: schematically shows the implanted semiconductor substrate of Figure 9 after bonding with another semiconductor substrate with another crystal orientation;
- Figure 11: schematically shows the compound of bonded semiconductor substrates of Figure 10 after a detachment step of a part of the first semiconductor substrate;
- Figure 12: schematically shows the compound of Figure 11 after an oxide dissolution step by heat treatment.

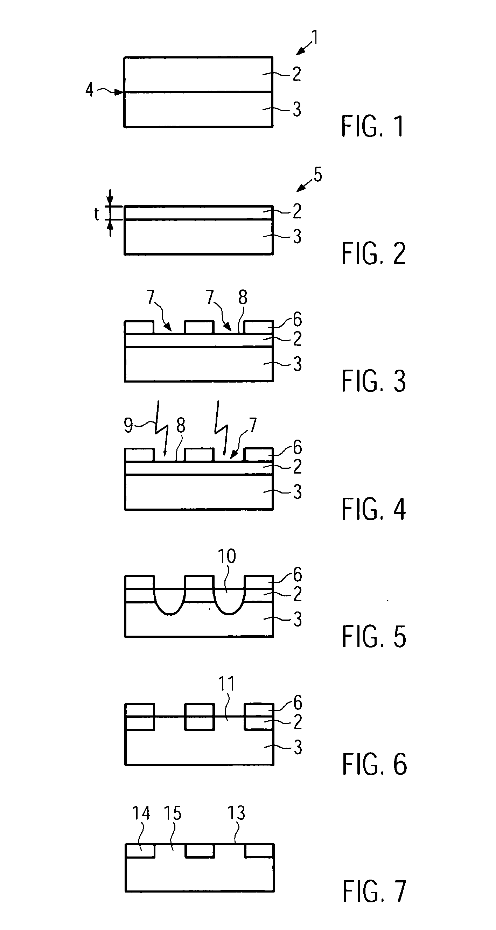

Figures 1 to 6 schematically show a flow of process steps according to a favourite embodiment of the method of the present invention.

Figure 1 schematically shows a compound 1 of a first semiconductor substrate 2 and a second semiconductor substrate 3 being bonded with each other by hydrophobic or hydrophilic direct wafer bonding (DSB). In the example shown in Figure 1, the first semiconductor substrate 2 is a silicon wafer with (110) crystal orientation and the second semiconductor substrate 3 is a silicon wafer with (100) crystal orientation. In other embodiments of the present invention, the upper (first) semiconductor substrate can have a (100) crystal orientation, wherein the second semiconductor substrate 3 at the bottom of the compound 1 can have a (110) crystal orientation. The semiconductor substrates 2, 3 are not limited to silicon but can be, in other embodiments of the invention, of other semiconductor materials like germanium or SiGe.

Before the semiconductor substrates 2, 3 are bonded, a surface preparation treatment comprising cleaning, brushing and plasma activation is applied on at least one of the bonded semiconductor substrates 2, 3.

After bonding of the semiconductor substrates 2, 3, a heat treatment is applied to strengthen the bonding interface 4. During this heat treatment, a temperature from about 200 °C to about 1200 °C is applied during a time of about 30 minutes to about 10 hours.

Figure 2 schematically shows a compound 5 resulting from the compound 1 of Figure 1. The compound 5 consists of the second semiconductor substrate 3 and a residual part of the first semiconductor substrate 2. The thickness of the first semiconductor substrate 2 is, in comparison to compound 1 of Figure 1, reduced by grinding and polishing using Chemical Mechanical Polishing (CMP). The final thickness *t* of the first semiconductor substrate 2 is between about 100 nm and about 200 nm. A precise adjustment of the thickness *t* of the first semiconductor substrate 2 can be achieved by providing an etch stop in the first semiconductor substrate 2 before the bonding step shown in Figure 1.

Figure 3 schematically shows the compound 5 of Figure 2 after providing a mask 6 on the first semiconductor substrate 2. The mask 6 was patterned by a photolithography step resulting in openings 7 in the mask 6, said openings 7 exposing certain surface areas 8 of the first semiconductor substrate 2 being on top of the compound 5.

Figure 4 schematically shows the compound of Figure 3 during a laser treatment with laser beams 9. The laser treatment is carried in the example shown in Figure 4 by a pulsed XeCl excimer laser with a wavelength of 308 nm and a pulse duration of 28 nm. The laser apparatus is equipped with a beam homogenizer with an energy density above 1 J/cm². In other not-shown examples of the present invention, another laser apparatus can also be used.

The laser treatment of Figure 4 is applied on the unmasked regions 8 of the surface of the first semiconductor substrate 2 provided by the openings 7 in the mask 6. The laser treatment of Figure 4 leads to an annealing of the first semiconductor substrate 2 in the opened areas. During this annealing step, the temperature of the first semiconductor substrate 2 can reach up to the melting point of Si, i.e. 1414 °C.

Figure 5 schematically shows the compound of Figure 4 with melted regions 10 resulting from the laser treatment shown in Figure 4. The locally melted regions 10 comprise the unmasked bulk regions of the first semiconductor substrate 2, wherein under the openings 7 of the mask 6 the whole thickness of the semiconductor substrate 2 is melted. Furthermore, the region of the interface 4 between the first semiconductor substrate 2 and the second semiconductor substrate 3 under the openings 7 of the mask 6 as well as at least an upper part of the bulk region of the second semiconductor substrate 3 is melted.

Figure 6 schematically shows the compound of Figure 5 after recrystallization of the melted regions 10. The recrystallization occurs when the temperature of the compound shown in Figure 5 decreases from melting temperature to room temperature. The recrystallization is comparable with a liquid phase epitaxy wherein the seed for the recrystallization is the supporting second semiconductor substrate 3.

Although not shown in the figures, shallow trench isolations (STI) can be formed at least in the first semiconductor substrate 2 before the melting step shown in Figures 4 and 5 to define regions of the first semiconductor substrate 2 in which the crystal orientation is to be changed. The shallow trench isolations help to avoid a lateral templating and are also favourable to set mark alignments.

The material in the recrystallized regions 11 of the compound shown in Figure 6 has the same crystal orientation as the underlying second semiconductor substrate 3, wherein the material has a very good crystal quality with nearly no or only a negligible amount of defects.

Figure 7 schematically shows the compound of Figure 6 after removal of the mask 6. The structure of the Figure 7 is a hybrid orientation substrate 12 having on its surface 13 regions 14 with (110) crystal orientation resulting from the first (upper) semiconductor substrate 2 and regions 15 with (100) crystal orientation resulting from the second (support) semiconductor substrate 3. As mentioned above, in dependence on the structure of the bonded compound 1 of Figure 1, the resulting hybrid orientation substrate can also have another structure having a support and recrystallized regions on the surface of (110) oriented material wherein the other regions at the surface are of (100) oriented semiconductor material. It is apparent from the above description that in these other embodiments of the invention, other semiconductor materials and/or other crystal orientations of the semiconductor materials can be used.

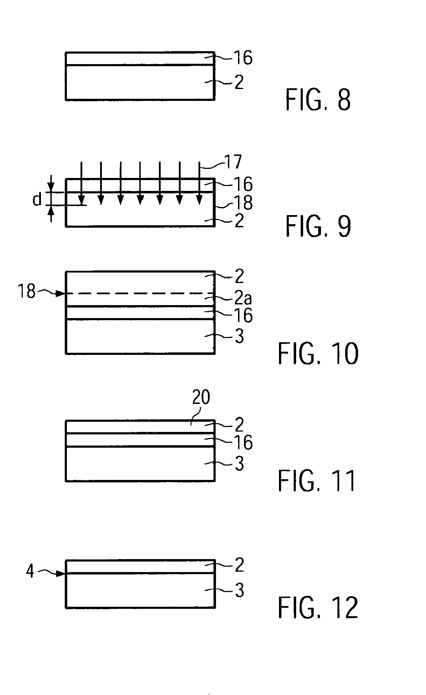

Figures 8 to 12 schematically show process steps that can precede the process steps shown in Figures 1 to 7.

Figure 8 schematically shows a first semiconductor substrate 2 with a first crystal orientation. In the embodiment shown in Figure 8, the first semiconductor substrate 2 is a (110) oriented silicon donor substrate. On top of the semiconductor substrate 2, an insulator layer 16 is formed. In the shown embodiment, the insulator layer 16 is a silicon dioxide layer. The silicon dioxide layer 16 can be a native oxide with a thickness of about a few atomic layers corresponding to a thickness of 0.5 to 1.5 nm. In other embodiments of the invention, the silicon dioxide layer 16 can be formed on the first semiconductor substrate 2 by a thermal oxidation in a wet or dry way or by a deposition process such as chemical vapour deposition (CVD), particularly low pressure CVD.

The insulator layer 16 has a thickness being less than 200 nm, preferably less than 100 nm and more particularly being between 25 and 50 nm.

Figure 9 schematically shows the structure of Figure 8 during an implantation step. During implantation, the structure of Figure 8 is implanted or co-implanted with a atomic species 17 like hydrogen or helium. For H-only implantation a dose of about 6 x 10¹⁶ cm⁻² and an energy of around 45 keV is used. For He and H co-implantation a dose of about 1 x 10¹⁶ cm⁻² and an energy of around 45 keV, and for helium implantation a dose of about 1 x 10¹⁶ cm⁻² and an energy of about 80 keV is used. The implantation results in the formation of a pre-weakened zone 18 in a certain depth d in the first semiconductor substrate 2.

Then follows a surface preparation step using a cleaning step such as RC cleaning, a brushing step and a plasma activation step in a nitrogen or oxygen atmosphere. The surface preparation step helps to prepare the surface of the implanted structure of Figures 8 and 9 for the following bonding step.

Figure 10 schematically shows the implanted structure of Figure 9 being bonded on the side of the insulator layer 16 with a second semiconductor substrate 3. The second semiconductor substrate 3 forms a support substrate and has another crystal orientation than the material of the first semiconductor substrate 2. In the shown example, the second semiconductor substrate 3 is of silicon with (100) crystal orientation. In other examples of the invention, the semiconductor substrates 2 and 3 can also be of another material than silicon and can also have other but in each case different crystal orientations.

Figure 11 schematically shows the compound of Figure 10 after a heat treatment step. During said heat treatment, a temperature between about 500 °C to about 1250 °C is applied to the structure of Figure 10 to detach a part 19 from the first semiconductor substrate 2. The part 19 is split from the structure shown in Figure 10 along the pre-weakened zone 18 formed by the foregoing implantation step.

As shown in Figure 11, a residual part 20 of the first semiconductor substrate 2 is still bonded with the second semiconductor substrate 3 after the detachment step, wherein the insulator layer 16 is between the materials with the different crystal orientations.

Figure 12 schematically shows the structure of Figure 11 after a further heat treatment step. In this heat treatment step, a temperature between about 1000 °C and 1300 °C is applied to dissolve the insulator layer 16 between the different materials of the semiconductor substrates 2, 3. In the example shown, the heat treatment leads to oxide dissolution of the silicon dioxide layer 16. The oxide dissolution step is applied under inert and/or reductive atmosphere to dissolve the oxide layer 16 at the interface.

Thereafter, the structure shown in Figure 12 can be used for further processing according to Figures 1 to 7 to form a hybrid orientation substrate.

As shown by the Figures 8 to 12, the present invention can be applied on direct silicon bonded (DSB) substrates obtained by a Smart Cut^{™} process wherein the DSB substrates can be obtained by hydrophobic as well as by hydrophilic bonding. But as shown by the Figures 1 to 7, the invention can be applied on any substrate obtained by other techniques than Smart Cut^{™}, like for example the BESOI technique, leading to direct bonded substrates or layers consisting preferably of the same chemical substance but having different crystalline orientations.

In comparison to the known prior art processes to form hybrid orientation substrates, with the present invention, hybrid orientation substrates without any defects by melting selected areas of a DSB substrate and recrystallizing them with the same orientation as the support substrate can be produced. The method according to the present invention is a quick method, easy to apply and not limited to a precise top layer thickness.

The mask 6 deposited on the surface 8 of the compound 5 of Figure 2 is a Bragg reflector adapted for a laser wavelength. In the case of an XeCl excimer pulsed laser operating at the wavelength of 308 nm, the stack used for the mask 6 is as follows: three SiO₂/Si₃N₄ pairs (52 nm / 40 nm) finally covered by 100 nm SiO₂. The mask 6 is patterned by photolithography and reactive ion etching (RIE).

It is the main advantage of the method of the present invention in comparison to ATR techniques that no defects will appear during the recrystallization step. In particular, defects induced by the implantation step used in ATR techniques usually obtained after recrystallization do not occur.

Furthermore, the laser annealing process used in the present invention can dissolve oxygen islands as well as small precipitates present at the bonding interface of the DSB substrates so that no seed for the formation of defects is present at that interface after the melting step performed by laser annealing. In this way, the formation of defects can be prevented.

## Claims

1. A method for fabricating a semiconductor substrate (12) having on its surface (13) areas (14, 15) with different crystal orientation, the method comprising the steps of bonding of a first semiconductor substrate (2) with a second semiconductor substrate (3), said semiconductor substrates (2, 3) having bulk regions with different crystal orientation; forming a mask (6) on the surface (8) of the first semiconductor substrate (2), said mask (6) being reflective for laser light; forming openings (7) in said mask (6) to expose unmasked bulk regions of the first semiconductor substrate (2); exposing at least said openings (7) to laser light (9) and melting locally the unmasked bulk regions of said first semiconductor substrate (2) and at least a part of the bulk region of the second semiconductor substrate (3) with said laser light (9).

2. The method of claim 1, wherein at least residual oxide and/or oxygen particles at an interface between the first semiconductor substrate (2) and the second semiconductor substrate (3) are dissolved by said melting step.

3. The method of claim 1 or 2, wherein said bonding step comprises bonding of a first silicon wafer with (110) orientation and a second silicon wafer with (100) orientation.

4. The method of one of the previous claims, wherein the thickness of the first semiconductor substrate (2) is reduced before the melting step to a thickness of about 100 nm to about 200 nm.

5. The method of one of the previous claims, wherein said bonding step comprises bonding of a first substrate having a bulk region of silicon with a first crystal orientation and having at least an insulator layer (16) on its surface with a second substrate having a bulk region of silicon with a second crystal orientation, resulting in a compound of substrates having said insulator layer (16) at an interface between the silicon regions of the first and the second substrates, wherein a heat treatment with a temperature between about 1000 °C and about 1300 °C is applied on said compound to dissolve said insulator layer (16) at said interface.

6. The method of claim 5, wherein said insulator layer (16) is of silicon dioxide, being a native oxide and/or being formed on the first substrate by thermal oxidation or by chemical vapour deposition.

7. The method of claim 5 or 6, wherein said insulator layer (16) is being formed on the first substrate with a thickness of less than 200 nm, preferably with a thickness of less than 100 nm, and more particularly with a thickness between about 25 nm and about 50 nm.

8. The method of one of the previous claims, wherein a heat treatment with a temperature between about 200 °C and 1200 °C is applied on the bonded semiconductor substrates (2, 3) after the bonding step.

9. The method of one of the claims 5 to 7, wherein the first substrate is implanted before bonding.

10. The method of claim 9, wherein a layer from said first substrate is detached after said bonding step by applying a heat treatment with a temperature between about 500 °C and about 1250 °C.

11. The method of one of the previous claims, wherein said laser light (9) is applied by a pulsed laser apparatus.

12. The method of one of the previous claims, wherein said laser light (9) is applied with a XeCl excimer laser equipped with a beam homogenizer.

13. The method of one of the previous claims, wherein at least in the first semiconductor substrate (2) shallow trench isolations are formed before the melting step to define regions of the first semiconductor substrate (2) in which the crystal orientation is to change.
